# EUROPÄISCHE PATENTANMELDUNG

(11) **EP 1 758 237 A1**
(43) Veröffentlichungstag der Anmeldung: **28.02.2007**
(21) Anmeldenummer: 06118028.7
(22) Anmeldetag: 28.07.2006
(51) Int. Cl.: H02N 2/04, F02M 51/00

(54) **Anordnung mit einem Piezoaktor und ein Verfahren zu dessen Herstellung**

(30) Priorität: 22.08.2005 DE 102005039567
(71) Anmelder: ROBERT BOSCH GMBH, 70442 Stuttgart (DE)
(72) Erfinder: Heinz, Rudolf, 71272, Renningen (DE); Kienzler, Dieter, 71229, Leonberg (DE); Schaich, Udo, 70378, Stuttgart (DE)

(57) **Zusammenfassung**

Es wird eine Anordnung mit einem Piezoaktor, beispielsweise zur Betätigung eines mechanischen Bauteils, vorgeschlagen, mit einem Mehrschichtaufbau von Piezolagen (26), die als Bestandteil eines Piezoelements (3;21) in einem Haltekörper (2;29,30) gehalten sind, wobei am Piezoelement (3;21) eine innere wechselseitige Kontaktierung von Innenelektroden (22,23) mit Kontaktelementen (24,25) vorhanden ist und mit elektrischen Leitungen (34,35), die durch ein Kopfteil (30) des Haltekörpers (29) zu den Kontaktelementen (24,25) geführt sind Die elektrischen Leitungen (34,35), die durch ein Kopfteil (30) des Haltekörpers (29) zu den Kontaktelementen (24,25) geführt sind, sind im Aktorfuß hochdruckdicht zum Piezoelement (21) hin eingebettet, wobei diese vorzugsweise in einer Glaseinschmelzung (40,41) liegen.

## Beschreibung

### Technisches Gebiet

Die Erfindung betrifft eine Anordnung mit einem Piezoaktor, beispielsweise als Piezoinjektor oder zur Betätigung eines mechanischen Bauteils wie ein Ventil oder dergleichen, und ein Verfahren zu dessen Herstellung nach den gattungsgemäßen Merkmalen des Hauptanspruchs.

### Stand der Technik

Es ist an sich bekannt, dass zum Aufbau des zuvor erwähnten Piezoaktors ein Piezoelement so eingesetzt werden kann, dass unter Ausnutzung des sogenannten Piezoeffekts eine Steuerung des Nadelhubes eines Ventils oder dergleichen vorgenommen werden kann. Das Piezoelement ist aus einem Material mit einer geeigneten Kristallstruktur so aufgebaut, dass bei Anlage einer äußeren elektrischen Spannung eine mechanische Reaktion des Piezoelements erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor aus der DE 100 26 005 A1 bekannt, der zur Ansteuerung der Düsennadel bei Injektoren zur Einspritzung von Kraftstoff in den Brennraum eines Verbrennungsmotors verwendet werden kann. Bei diesem Piezoaktor ist ein Piezoelement, wie erwähnt, als Stapel mehrerer elektrisch miteinander gekoppelter piezokeramischen Schichten aufgebaut, der unter Vorspannung zwischen zwei Anschlägen gehalten ist. Jede piezokeramische Schicht ist als Piezolage zwischen zwei Innenelektroden eingefasst über die von außen eine elektrische Spannung angelegt werden kann. Aufgrund dieser elektrischen Spannung führen die piezokeramischen Schichten dann jeweils kleine Hubbewegungen in Richtung des Potentialgefälles aus, die sich zum Gesamthub des Piezoaktors addieren. Dieser Gesamthub ist über die Höhe der angelegten Spannung veränderbar und kann auf ein mechanisches Stellglied übertragen werden.

Bei dem zuvor erwähnten Piezoaktor wird zur Heranführung der unterschiedlichen Potentiale eine wechselseitige seitliche Kontaktierung der Innenelektroden über äußere Elektroden vorgenommen, bei der leitende Flächen auf jeweils einer Seitenfläche des Piezoelements angebracht sind, die mit den jeweiligen Innenelektroden kontaktiert sind. Dagegen ist aus der DE 103 35 019 A1 ein Piezoaktor bekannt, bei dem die Kontaktierung der Innenelektroden mit Kontaktelementen erfolgt, die jeweils in einer inneren Ausnehmung des Piezoelements liegen.

Außerdem ist auch in der EP 1 174 615 A3 ein Piezoaktor bzw. ein Piezoinjektor beschrieben, bei dem ein Piezoelement als Aktor für die direkte Nadelhubsteuerung eines Einspritzinjektors für einen Verbrennungsmotor vorhanden ist. Zwischen dem Piezoelement als Aktor und der Nadel sitzt lediglich ein Koppler mit einer hydraulischen Übersetzung zum Dehnungsausgleich. Mit einer Aktivierung des Piezoelements wird hierbei die unter Vorspannung zum Verschluss der Einspritzdüse gehaltene Nadel von der Düsenöffnung wegbewegt, da die Nadel direkt übersetzt der Bewegung des Aktors folgt.

Beim eingangs erwähnten Stand der Technik DE 100 26 005 wird der elektrische Anschluss des Piezoelements an eine externe Spannungsquelle durch eine Verlängerung der äußeren Elektroden durch ein Fußteil des Piezoaktors hindurch vorgenommen. Diese Verlängerung kann auch weiter bis zu einem Stecker geführt werden, so dass diese somit in einem mechanisch unkritischen Bereich kontaktiert werden. Die Verlängerungen können dabei elektrisch isoliert durch den Aktorfuß, z.B. aus Stahl, geführt werden, an dem das Piezoelement anliegt oder befestigt ist. Weiterhin ist es aus diesem Stand der Technik bekannt, dass die Verlängerungen zur Fixierung und zur Zugentlastung der Außenelektroden in einer Vergussmasse gehalten sind, welche in eine Ausnehmung des Aktorfußes, ggf. von einem Formteil aus Stahl oder Polymer umgeben, eingebracht sind.

Bei den zuvor beschriebenen Piezoaktoren ist zu beachten, dass die elektrischen Anbindungen im Herstellungsprozess einfach aber im Betrieb sicher erfolgen sollen, wobei zusätzlich zur elektrischen Isolierung auch bei vielen Anwendungen mit einer Ventilfunktion eine ausreichende Abdichtung gegenüber Flüssigkeiten gewährleistet sein muss. Insbesondere bei einer Anwendung der Piezoaktoren als Einspritzinjektoren für Kraftstoff in sogenannten Common-Rail-Systemen (CR) ist bei den verwendeten hohen Drücken des Kraftstoffs eine sichere Bauweise erforderlich.

### Offenbarung der Erfindung

Die Erfindung geht von einer eingangs beschriebenen Anordnung mit einem Piezoaktor aus, der einen Mehrschichtaufbau von Piezolagen in einem Piezoelement aufweist und an einem Haltekörper gehalten ist, wobei am Piezoelement eine wechselseitige Kontaktierung von Innenelektroden mit Kontaktelementen vorhanden ist. Es sind weiterhin Zuführdrähte als elektrische Leitungen durch ein Kopfteil des Haltekörpers zu den Kontaktelementen geführt. Gemäß der Erfindung sind in vorteilhafter Weise die elektrischen Leitungen, die durch ein Kopfteil des Haltekörpers zu den Kontaktelementen geführt sind, im Aktorfuß hochdruckdicht zu den Piezolagen im Piezoelement hin eingebettet. Eine solche Anordnung ist beispielsweise vorteilhaft als Piezoinjektor zur Steuerung des Hubs einer Nadel für die Kraftstoffeinspritzung in einem Kraftfahrzeug einsetzbar und zwar sowohl mit einer einstufigen als auch mit einer zweistufigen Übersetzung. Die elektrischen Leitungen sind in vorteilhafter Weise in einer Glaseinschmelzung eingebettet, so dass die elektrischen Kontaktierungen des Piezoelements auf einfache Weise eine gute Hochdruckabdichtung gegenüber der im Piezoinjektor vorhandenen Flüssigkeiten aufweist.

Durch die erfindungsgemäße Glaseinschmelzung der Zuführdrähte in den Aktorfuß ist ein kompaktes Aktormodul realisierbar, da in diesem Aktorfuß alle elektrischen Leitungs- und hydraulischen Dichtfunktionen eingebracht sind. Ein Glaseinschmelzung im zunächst freiliegenden Aktorfuß ist gut montier- und prüfbar und die Kontaktelemente des Piezoelements können bei der Anbringung an den Aktorfuß einfach kontrolliert und danach in die Piezolagen des Piezoelements geschoben werden. Bei Bedarf kann auch ein Draht mit hoher elektrischer Leitfähigkeit oberhalb der Glaseinschmelzung kontaktiert werden, wobei eine gute elektrische und mechanische Kontrolle möglich ist.

Außerdem ist die abschließende Verschweißung des Aktorfußes mit dem Kopfteil auch gut prüfbar, da die Glaseinschmelzung unten sitzt und mit Heliumgas eine Dichtheitsprüfung nach oben leicht durchführbar ist. Auf einfache Weise ist mit der erfindungsgemäßen Lösung eine kundenspezifische Längenanpassung der Anordnung über eine variable Längenanpassung des Zuführdrahtes möglich.

Eine Kontaktverbindung ist durch Verschweißen oder Löten der sich jeweils gegenüber liegenden Enden der Leitungen und der Kontaktelemente herstellbar; andererseits können die Leitungen auch direkt zu den Kontaktelementen geführt sein. Die Leitungen können auch über eine weitere Verbindungsstelle im Bereich des Anschlusses des Aktorfußes an das Kopfteil an die Weiterführung zu den Kontaktelementen angeschlossen werden.

Gemäß eines vorteilhaften Verfahrens zur Herstellung einer erfindungsgemäßen Anordnung mit einem Piezoaktor, insbesondere eines Piezoinjektors, werden in einem ersten Verfahrensschritt die Kontaktelemente mittels der Kontaktverbindungen an die Leitungen angefügt und in einem zweiten Verfahrensschritt wird das Piezoelement mit dem Aktorfuß über die Kontaktelemente geschoben und dann der Aktorfuß mit dem Kopfteil des Haltekörpers fest verbunden. Die Hochdruckdichtigkeit der Anordnung kann auch noch durch eine Helium-Einströmprüfung in den Bereich des Piezoelements vorgenommen werden.

### Kurze Beschreibung der Zeichnungen

Ausführungsbeispiele der erfindungsgemäßen Anordnung werden anhand der Zeichnungen erläutert. Es zeigen:
Figur 1 einen Längsschnitt durch eine Anordnung mit einem Piezoaktor mit einem prinzipiellen geometrischen Aufbau nach dem Stand der Technik mit außenliegender Kontaktierung der Innenelektroden und
Figur 2 einen Teillängsschnitt durch ein erfindungsgemäßes Ausführungsbeispiel eines Piezoaktors in einem Haltekörper mit innenliegender Kontaktierung und einer Glaseinschmelzung der Kontaktelemente im Fußteil des Piezoaktors.

### Ausführungsform(en) der Erfindung

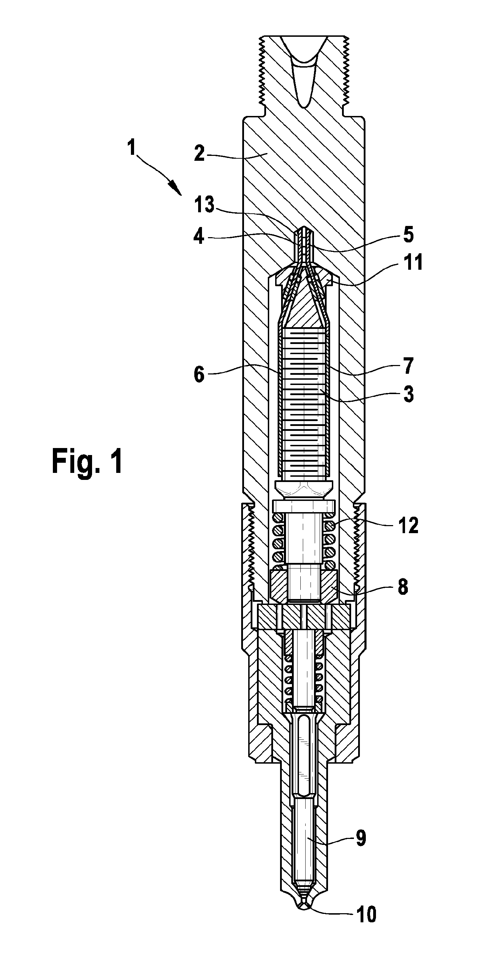

In Figur 1 ist ein prinzipieller Aufbau eines einstufigen Piezoinjektors 1 gezeigt, bei dem ein Piezoaktor zur direkten Nadelhubsteuerung einer Düsennadel im Einspritzsystem für Kraftstoff bei einem Verbrennungsmotor eingesetzt werden kann. Im oberen Teil ist ein Haltekörper 2 vorhanden, der in seinen geometrischen Abmessungen im wesentlichen an den spezifischen Einsatzort angepasst werden kann. Am Haltekörper 2 ist ein hier nicht dargestelltes Steckerteil vorhanden, durch das mit einer ebenfalls spezifisch an den Anwendungsfall angepassten Steckerausführung die elektrische Spannung zur Ansteuerung eines Piezoelements 3 angeschlossen werden kann.

Vom Steckerteil sind hier Zuführdrähte als elektrische Leitungen 4 und 5 zu Außenelektroden 6 und 7 am Piezoelement 3 geführt, das bei einer Betätigung über eine sich hier senkrecht unterhalb befindliche mechanische Anordnung mit einem Koppler 8 auf eine Düsennadel 9 derart wirkt, dass hier eine Freigabe einer Düsenöffnung 10 erfolgen kann. Ein im Inneren des Piezoinjektors 1 durch den Innenraum des Haltekörpers 2 geführter Kraftstoff kann somit in den Brennraum eines hier nicht dargestellten Verbrennungsmotors injiziert werden.

Die Piezolagen des Piezoelement 3 liegen nach der Figur 1 über einen Aktorfuß 11 oben an einem balligen Dichtsitz im Innenraum des Haltekörpers 2 an, wobei das Piezoelement 3 zur Bewirkung eines guten Dichtsitzes mit einer Feder 12 angedrückt wird. Insbesondere bei den eingangs erwähnten Common-Rail (CR)-Systemen ist hier eine Hochdruckabdichtung zu einem elektrischen Anschlussraum 13 notwendig, durch den die zwei elektrischen Leitungen 4 und 5 an das Piezoelement 3 geführt sind.

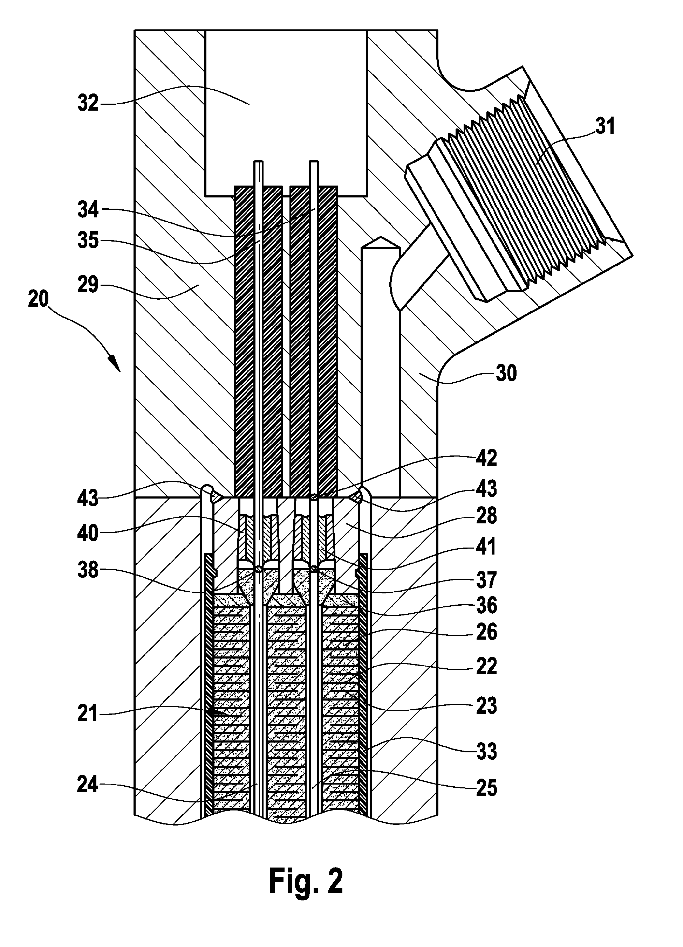

Aus Figur 2 ist ein Teil eines erfindungsgemäßen Piezoinjektors 20 im zusammengebauten Zustand zu entnehmen. Es ist hier ein Piezoelement 21 vorhanden, bei dem hier nur beispielhaft Innenelektroden 22 und 23 mit einem Bezugszeichen versehen sind, die im Stapelaufbau des Piezoelements 21 wechselseitig jeweils über eine innere Kontaktelemente 24 und 25 mit einer elektrischen Spannung versorgt werden. Die Kontaktelemente 24 und 25 kontaktieren die Innenelektroden 22 und 23 in einer hier nicht dargestellten Weise über Bürsten, über einen Leitkleber oder weisen eine hierfür geeignete Formgebung, zum Beispiel mit einer spiralförmigen Drahtführung auf. Durch das Potentialgefälle bei Anlage einer Spannung wird die in der Beschreibungseinleitung erläuterte mechanische Reaktion in den Piezolagen 26 aus Keramikfolien dann zwischen den Innenelektroden 22 und 23 bewirkt.

Das Piezoelement 21 liegt weiterhin über einen Aktorfuß 28, vorzugsweise aus Stahl, am Haltekörper 29 des Piezoinjektors 20 an, wobei dieser ein Kopfteil 30 aufweist, das zum einen eine Kraftstoffzufuhr 31 und eine elektrisches Anschlussteil 32 aufweist. Das Piezoelement 21 ist gegenüber dem Kraftstoff im Inneren des Haltekörpers 29 noch mit einer äußeren Isolationsschicht 33 abgedichtet.

Im Inneren des Kopfteils 30 sind Zuführdrähte als Leitungen 34 und 35 isoliert eingefügt, die zum Anschluss an das Piezoelement 21 hochdruckdicht zum Aktorfuß 28 geführt sind. Im oberen Teil des Piezoelements 21 sind passive Piezolagen 36, wobei hier der mechanische Anschluss und somit die Kraftübertragung zum Aktorfuß 28 erfolgt. Die zuvor erwähnte Kontaktierung der Innenelektroden 22 und 23 sollte je nach Aufbau des Piezoelements 21 so ausgeführt sein, dass die Kontaktelemente 24 und 25 entweder am Aktorfuß 28 direkt mit den Leitungen 34 und 35 als Zuführungsdrähte an Kontaktstellen 37 und 38 verschweißt oder verlötet werden können oder dass auch der Zuführungsdraht der Leitungen 34 und 35 direkt als Kontaktelement 24 und 25 verwendet werden kann.

Im Aktorkopf 28 sind Glaseinschmelzungen 40 und 41 integriert, mit denen eine Hochdruckabdichtung der im Haltekörper befindlichen Flüssigkeit zum Piezoelement 21 hinsichtlich der durchgeführten Leitungen 34 und 35 möglich ist. Hier kann entweder der Draht der Leitung 35 weitergeführt werden oder es kann an einer Verbindungsstelle 42 ein eventuell besser leitfähiger Draht an die Leitung 34 angeschweißt, angelötet oder angekrimpt werden.

Der Aktorfuß 28 ist dann mit einer hochdruckdichten Schweißnaht 43 zum Kopfteil 30 des Haltekörpers 29 hochdruckdicht anfügbar, was eventuell mit einer Einleitung von Heliumgas hinsichtlich einer Leckage prüfbar ist.

### Gewerbliche Anwendbarkeit

Die Erfindung ist als Piezoinjektor zur Steuerung des Hubs einer Nadel für die Kraftstoffeinspritzung in einem Kraftfahrzeug gewerblich anwendbar.

## Patentansprüche

1. Anordnung mit einem Piezoaktor, mit
- einem Mehrschichtaufbau von Piezolagen (26), die in einem Piezoelement (3;21) an einem Haltekörper (2;29,30) gehalten sind, wobei am Piezoelement (3;21) eine innere wechselseitige Kontaktierung von Innenelektroden (22,23) mit Kontaktelementen (24,25) vorhanden ist und mit
- elektrischen Leitungen (34,35), die durch ein Kopfteil (30) des Haltekörpers (29) zu den Kontaktelementen (24,25) geführt sind, **dadurch gekennzeichnet, dass**
- die elektrischen Leitungen (34,35), die durch ein Kopfteil (30) des Haltekörpers (29) zu den Kontaktelementen (24,25) geführt sind, im Aktorfuß hochdruckdicht zum Piezoelement (21) hin eingebettet sind.

2. Anordnung nach Anspruch 1, **dadurch gekennzeichnet, dass**
- die elektrischen Leitungen (34,35) in einer Glaseinschmelzung (40,41) eingebettet sind.

3. Anordnung nach Anspruch 1 oder 2, **dadurch gekennzeichnet, dass**
- die Kontaktverbindungen (37,38) durch Verschweißen oder Löten der sich jeweils gegenüber liegenden Enden der Leitungen (34,35) und der Kontaktelemente (24,25) herstellbar ist.

4. Piezoaktor nach Anspruch 1 oder 2, **dadurch gekennzeichnet, dass**
- die Leitungen (34,35) direkt zu den Kontaktelementen (24,25) geführt sind.

5. Anordnung nach Anspruch 3 oder 4, **dadurch gekennzeichnet, dass**
- die Leitungen (34,35) über eine Verbindungsstelle (42) im Bereich des Anschlusses des Aktorfußes (28) an das Kopfteil (30) und an die Weiterführungen zu den Kontaktelementen (24,25) angeschlossen sind.

6. Verfahren zur Herstellung eines Piezoaktors nach einem der vorhergehenden Ansprüche, **dadurch gekennzeichnet, dass**
- in einem ersten Verfahrensschritt die Kontaktelemente (24,25) mittels der Kontaktverbindungen ((37,38) an die Leitungen (34,35) angefügt werden und
- in einem zweiten Verfahrensschritt die Piezolagen des Piezoelements (21) mit dem Aktorfuß (28) über die Kontaktelemente (34,35) geschoben und dann der Aktorfuß (28) mit dem Kopfteil (30) des Haltekörpers (29) fest verbunden wird.

7. Verfahren nach Anspruch 6, **dadurch gekennzeichnet, dass**
- eine Hochdruckdichtigkeitsprüfung der Anordnung durch eine Helium-Einströmprüfung in den Bereich des Piezoelements (21) vorgenommen wird.
